# EUROPÄISCHE PATENTSCHRIFT

(11) **EP 1 742 306 B1**
(45) Veröffentlichungstag und Bekanntmachung des Hinweises auf die Patenterteilung: **07.05.2008**
(21) Anmeldenummer: 06013527.4
(22) Anmeldetag: 29.06.2006
(51) Int. Cl.: H01R 43/02

(54) **Anschlussstift-Array**
Pin array
Réseau de broches

(30) Priorität: 04.07.2005 DE 102005031431
(43) Veröffentlichungstag der Anmeldung: 10.01.2007
(73) Patentinhaber: Compagnie Deutsch GmbH, 82152 Martinsried (DE)
(72) Erfinder: Finzer, Carlo, 86453 Dasing-Rieden (DE)
(74) Vertreter: Englaender, Klaus

(56) Entgegenhaltungen:
- EP-A2- 0 193 289
- EP-A2- 0 723 309
- GB-A- 2 279 512
- US-A- 4 553 801

## Beschreibung

Die Erfindung betrifft ein Anschlussstift-Array zur Montage auf und Verlötung mit einer Leiterplatte.

Ein Anschlussstift-Array besteht aus einer Mehrzahl von in einem vorgegebenen Muster in Bezug aufeinander angeordneten Anschlussstiften, die einerseits mit einer Leiterplatte verlötbar sind und andererseits zum Anschluss eines Steckers dienen. Ein bevorzugtes Lötverfahren zum Verlöten eines Anschlussstift-Array mit einer Leiterplatte ist die so genannten Reflow-Verlötung. Grundlage dieses Verfahrens sind Lötinseln, die im Bereich eines Durchbruchs der Leiterplatte zur Aufnahme der Anschlussstifte des Anschlussstift-Array ausgebildet sind und nach Bestückung einer Leiterplatte mit dem Array in einem Heißluftofen erhitzt und verflüssigt werden, um die gewünschte Lötverbindung zwischen Anschlussbahnen der Leiterplatte und den Anschlussstiften zu erzielen. Dieses Lötverfahren ist deshalb bevorzugt, weil es einen hohen Durchsatz gewährleistet, da eine Vielzahl von Lötstellen gleichzeitig realisiert werden kann.

Dokument EP-A-0 723 309 offenbart den Gegenstand des Oberbegriffs des Anspruchs 1.

Eine Aufgabe der vorliegenden Erfindung besteht darin, ein Anschlussstift-Array zur Montage auf einer Leiterplatte zu schaffen, das so gestaltet ist, dass eine saubere Reflow-Verlötung für sämtliche Anschlussstifte des Array im Heißluftofen gewährleistet ist.

Gelöst wird diese Aufgabe durch die Merkmale des Anspruchs 1. Vorteilhafte Weiterbildungen der Erfindung sind in den Unteransprüchen angegeben.

Mit anderen Worten basiert das erfindungsgemäße Anschluss-Array auf einem Trägerkörper für die Anschlussstifte, der es einerseits gestattet, eine Vielzahl von Anschlussstiften mit einem einzigen Bestückungsvorgang auf einer Leiterplatte zu montieren, und der andererseits eine problemlose, zuverlässige Reflow-Verlötung der Anschlussstifte des Array auf einer Leiterplatte gewährleistet, da er so gestaltet ist, dass die heiße Luft in einem Heißluft-Reflow-Ofen die Lötinseln auf der Leiterplatte im Bereich der Anschlussstifte ungestört erreicht. Grundlage für eine diesbezügliche ungestörte Luftzirkulation sind Abstandhalter auf der Unterseite des Trägerkörpers und Durchbrüche im Trägerkörper zwischen den Anschlussstiften.

Der Trägerkörper des erfindungsgemäßen Anschlussstift-Array besitzt gitterartige Struktur mit sich kreuzenden, seitlich auf Abstand gesetzten Stegen, wobei die Anschlussstifte in den Kreuzungsstellen der Stege vorgesehen sind. Durch die sich kreuzenden, auf Abstand gesetzten Stege werden Durchbrüche im Trägerkörper bereitgestellt, die einen Luftaustausch zwischen Oberseite und Unterseite des Trägerkörpers gewährleisten. Um den Luftdurchtritt optimal zu gestalten, sind die Stege relativ zu ihrer Tiefenerstreckung in Richtung des Anschlussstifteverlaufs schmal gebildet, vorzugsweise mit einer Breite in etwa entsprechend dem Durchmesser der Anschlussstifte. Um die Stifte in diese schmalen Stege mechanisch dauerhaft einsetzen zu können, sind die Kreuzungsstellen der Stege, die die Anschlussstiftaufnahme darstellen, verstärkt ausgebildet.

Bevorzugt sind die verstärkten Kreuzungsstellen der Stege zur Stiftaufnahme als die Anschlussstifte umschließende, buchsenartige Bereiche des gitterartigen Trägerkörpers gebildet.

Die erfindungsgemäß zum Luftaustausch beitragenden Abstandhalter sind bevorzugt als von der Unterseite des Trägerkörpers vorstehende Stifte gebildet. Um die Druckbelastbarkeit des Anschlussstift-Array zu erhöhen, sind bevorzugt die Abstandhalterstifte in den Lücken zwischen den Anschlussstiften am Trägerkörper angeordnet.

Um die ordnungsgemäße Positionierung des Anschlussstift-Array auf einer Leiterplatte zu fördern, sind von der Unterseite des Trägerkörpers vorspringende Positionierungsvorsprünge vorgesehen, die zum Eingriff in Ausnehmungen der Leiterplatte bestimmt sind. Diese Positionierungsvorsprünge sind ebenfalls bevorzugt als Stifte gebildet. Beispielsweise sind zwei diagonal gegenüberliegende Positionierungsstifte an Ecken des Trägerkörpers vorgesehen.

Um eine problemlose automatische Bestückbarkeit mittels einer Unterdruckbestückungseinrichtung zu gewährleisten, ist vorgesehen, dass der Träger auf seiner Oberseite einen geschlossenen Flächenbereich zum Angriff eines Saugorgans einer entsprechenden Bestückungseinrichtung aufweist. Bevorzugt ist dieser geschlossene Flächenbereich anstelle eines Durchbruchs zwischen Anschlussstiften gebildet.

Der Trägerkörper des erfindungsgemäßen Anschlussstift-Array ist bevorzugt aus einem elektrisch isolierenden Kunststoff hergestellt. Die Anschlussstifte werden bei der Ausformung des Trägerkörpers in diesen eingeformt bzw. eingespritzt und sämtliche am Trägerkörper ausgebildeten Elemente sind einstückig mit diesem geformt.

Der Trägerkörper ist bevorzugt flach und allgemein quaderförmig gebildet.

Gegenstand der Erfindung bildet außerdem eine Leiterplatte, die mit zumindest einem Anschlussstift-Array bestückt ist, das erfindungsgemäß wie vorstehend angeführt ausgebildet ist.

Die Erfindung wird nachfolgend anhand der Zeichnung beispielhaft näher erläutert; in dieser zeigen:
Fig. 1 eine perspektivische Ansicht einer Ausführungsform des erfindungsgemäßen Anschlussstift-Array,
Fig. 2 eine perspektivische Ansicht des Trägerkörpers des erfindungsgemäßen Anschlussstift-Array von Fig. 1, der nicht mit Anschlussstiften bestückt ist,
Fig. 3 eine Draufsicht auf das Anschlussstift-Array von Fig. 1,
Fig. 4 eine Ansicht des Anschlussstift-Array von Fig. 1 von unten,
Fig. 5 eine Stirnseitenansicht des Anschlussstift-Array von Fig. 1, und
Fig. 6 eine Seitenansicht des Anschlussstift-Array von Fig. 1.

In den Figuren ist ein Anschlussstift-Array allgemein mit der Bezugsziffer 10 bezeichnet. Das Anschlussstift-Array 10 umfasst einen Trägerkörper 11 zur Halterung von Anschlussstiften, und eine Anzahl von Anschlussstiften, im vorliegenden Beispiel 18 Anschlussstifte 21-26, 31-36 und 43-46. Der Trägerkörper 11 ist als flaches, allgemein quaderförmiges Teil gebildet, und die Anschlussstifte sind in drei zueinander parallel verlaufenden Anschlussstiftlängsreihen 20, 30 und 40 angeordnet, die parallel zur Längserstreckung des Trägerkörpers 11 ausgerichtet sind. In der ersten Anschlussstiftlängsreihe 20 sind die Anschlussstifte 21-26 angeordnet und in der zweiten Anschlussstiftlängsreihe 30 sind die Anschlussstifte 31-36 angeordnet. In der dritten Anschlussstiftlängsreihe 40 sind die Anschlussstifte 43-46 angeordnet. In Quer- bzw. Breitenrichtung des Trägerkörpers 11 sind die Anschlussstifte ebenfalls parallel zueinander angeordnet, nämlich in Querreihen von jeweils drei Anschlussstiften 21, 31, 41; 22, 32, 42; 23, 33, 43; 24, 34, 44; 25, 35, 45 und 26, 36, 46. In jeder der Längs- und Querreihen sind die Anschlussstifte mit gegenseitig identischem Abstand angeordnet.

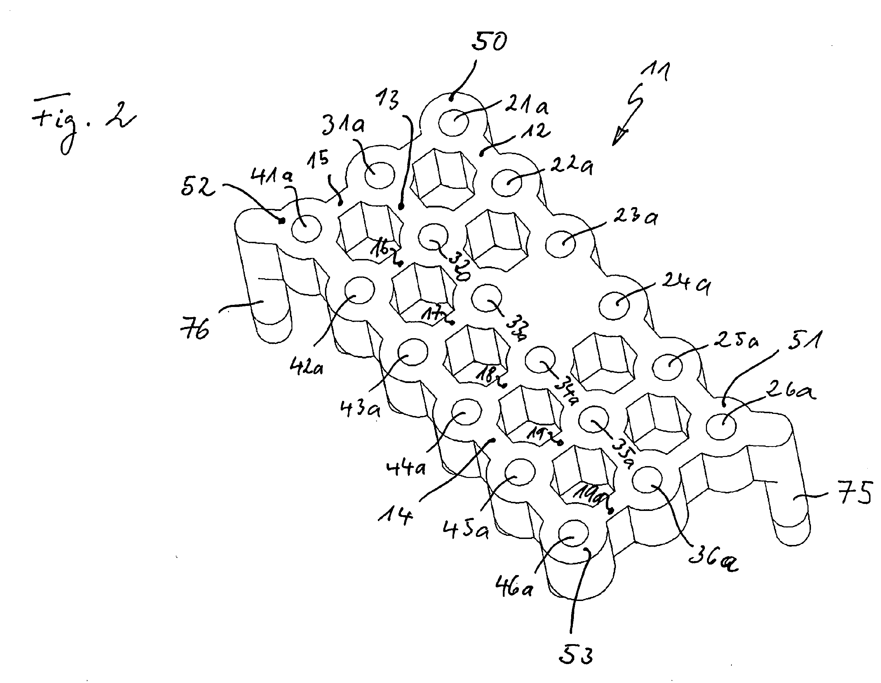

In Fig. 2 ist der Trägerkörper 11 ohne Anschlussstifte dargestellt. Zur Aufnahme der Anschlussstifte dienen im Trägerkörper 11 im Querschnitt kreisförmige, insgesamt kreiszylindrische Durchbrüche, die in Längs- und Querreihen mit gleichmäßigem gegenseitigem Abstand entsprechend der Anschlussstiftanordnung vorgesehen sind, d. h., Durchbrüche 21a-26a, Durchbrüche 31a-36a. Ein bevorzugtes Verfahren zur Herstellung des Anschlussstift-Array 10 sieht vor, dass die Anschlussstifte in den Trägerkörper 11 aus isolierendem Material eingeformt werden, beispielsweise in einem Spritzgussverfahren oder einem sonstigen Formgebungsverfahren, so dass die Stiftaufnahme-Durchbrüche, die in Fig. 2 gezeigt sind, in sofern hypothetischer Natur sind.

Ein wesentlicher Aspekt der Erfindung besteht darin, dass vorgesehen ist, den Trägerkörper 11 so auszubilden, dass dieser eine Reflow-Verlötung der Anschlussstifte mittels Lötinseln auf einer nicht dargestellten Leiterplatte in einem Heißluftofen nicht behindert. Aus diesem Grund ist der Trägerkörper 11 zum einen als durchbrochene Struktur ausgebildet und zum anderen mit Abstandhaltern versehen, damit der Trägerkörper 11 unter einem Abstand gegenüber der Leiterplatte bei der Montage zu liegen kommt. Im Einzelnen besitzt der Trägerkörper 11 allgemein gitterartige Struktur mit sich kreuzenden, seitlich auf Abstand gesetzten Stegen und Abstandhalterstifte, die von der Unterseite des Trägerkörpers 11 vorstehen.

Entsprechend den Längsreihen 20, 30 und 40 und Querreihen der Anschlussstifte 21-26, 31-36, 43-46 umfasst der Trägerkörper 11 drei Längsstege 12, 13 und 14, die von den Anschlussstiften 21-26, 31-36 bzw. 43-46 durchsetzt sind, sowie drei senkrecht zu den Längsstegen verlaufende Querstege 15, 16, 17, 18, 19 und 19a, die von den Anschlussstiften 21, 31, 41; 22, 32, 42; 23, 33, 43; 24, 34, 44; 25, 35, 45 und 26, 36, 46 durchsetzt sind. Die Längsstege 12, 13, 14 und die Querstege 15, 16, 17, 18, 19 und 19a sind gleich ausgebildet und besitzen Abmessungen, demnach die Stege schmaler als tief sind, wobei die Tiefe in Erstreckungsrichtung der Anschlussstifte verläuft. Um bei der beabsichtigt schmalen Ausbildung der Längsstege und Querstege die Anschlussstifte mechanisch sicher dauerhaft aufnehmen zu können, sind in den Kreuzungsstellen der Längsstege und Querstege Verdickungsbereiche in Gestalt und buchsenförmigen Elementen gebildet, von denen beispielhaft und um die Zeichnung nicht unübersichtlich zu machen, lediglich die Stiftaufnahmebuchsen an den Ecken des Trägerkörpers 11 mit Bezugsziffern bezeichnet sind, d. h. mit den Bezugsziffern 50, 51, 52 und 53.

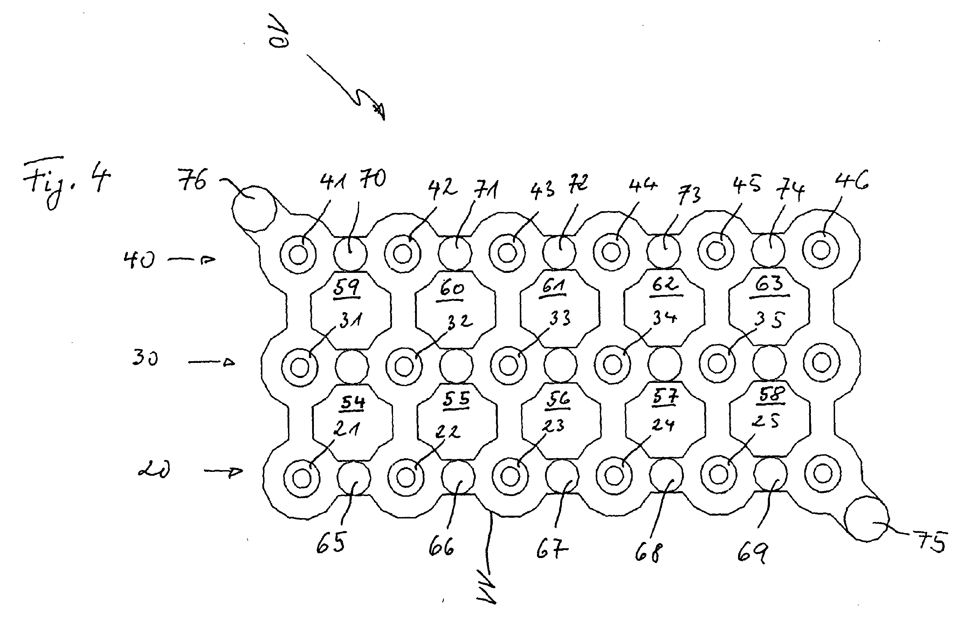

Die Gitterstruktur des Trägerkörpers 11 mit ihren Längsstegen und Querstegen legt in der dargestellten Ausführungsform zehn Durchbrüche fest, die in Fig. 4 mit den Bezugsziffern 54-63 bezeichnet sind, und in zwei Längsreihen 54-58 und 59-63 sowie fünf Querreihen 54-59; 55-60; 56-61; 57-62; und 58-63 angeordnet sind. Auf Grund der schmalen Ausbildung der Längs- und Querstege sind diese Durchbrüche 54-63 durch einen relativ großen freien Querschnitt gekennzeichnet, insbesondere durch einen allgemein quadratischen Querschnitt mit einwärts verlaufenden Eckenbereichen auf Grund der angrenzenden Stiftaufnahmebuchsen 50-53.

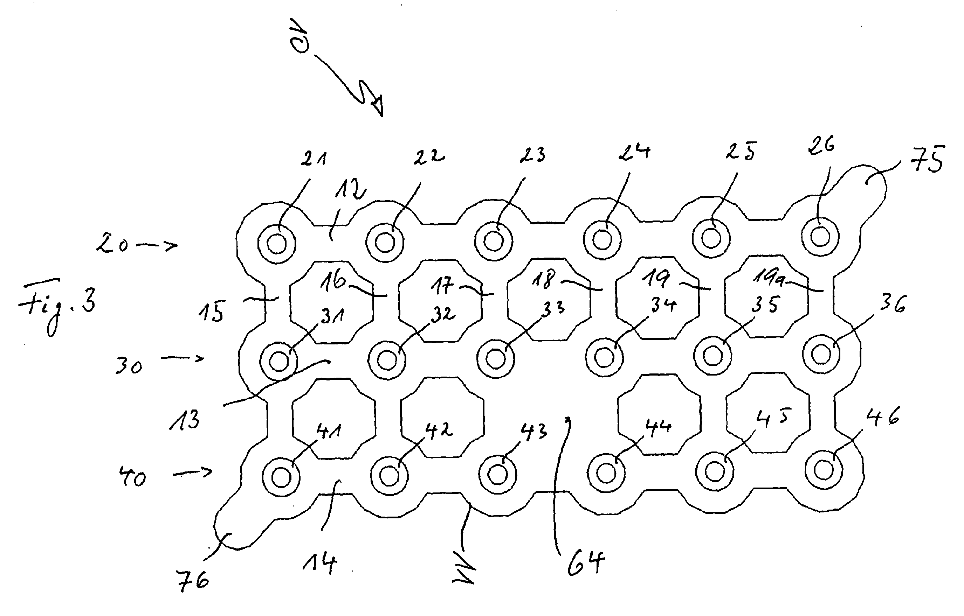

Wie beispielsweise aus Fig. 3 hervorgeht, die auf eine Draufsicht auf den Trägerkörper 11 darstellt, ist die Oberseite des Durchbruchs zwischen den Stiften 33, 34, 43, 44 verschlossen ausgebildet, und dieser geschlossene Flächenbereich ist mit der Bezugsziffer 64 bezeichnet. Der Flächenbereich 64 dient als Ansaugfläche für eine Unterdruckbestückungseinrichtung zum Bestücken einer Leiterplatte mit dem Trägerkörper 11.

Als vorstehend angesprochene Abstandhalter sind an dem Trägerkörper 11 bevorzugt durch Anformung an diesen Körper Abstandhalterstifte gebildet. Diese Abstandhalterstifte sitzen zwischen den Anschlussstiften 21-26, 31-36 und 43-46, so dass in jeder Längsreihe 20, 30, 40 fünf Anschlussstifte zu liegen kommen, von denen der Übersichtlichkeit halber in Fig. 4 lediglich die außen liegenden Abstandhalterstifte mit Bezugsziffern versehen sind, nämlich mit den Bezugsziffern 65-69 und 70-74, wobei die Abstandhalterstifte 65-69 zwischen den Anschlussstiften 21-26 zu liegen kommen, während die Abstandhalterstifte 70-74 zwischen den Anschlussstiften 43-46 zu liegen kommen.

Nicht sämtliche der in Fig. 4 gezeigten Abstandhalterstifte sind zwingend erforderlich, gewährleisten jedoch in ihrer Vielzahl die Aufnahme von auf das Anschlussstift-Array ausgeübten Druckkräften durch die Leiterplatte, wenn diese mit dem Array bestückt ist.

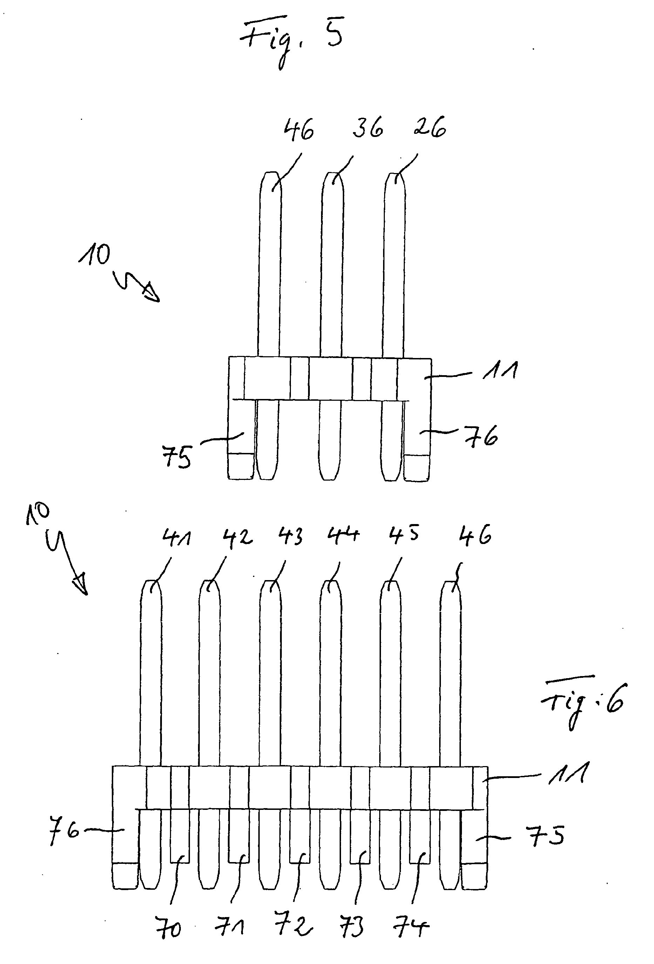

Die Abstandhalterstifte 65-69 und 70-74 sind dazu bestimmt, sich auf einer nicht dargestellten Leiterplatte abzustützen, weshalb ihre Längserstreckung ausgehend von der Unterseite des Trägerkörpers 11 um ein vorbestimmtes Maß kürzer ist als die Längserstreckung der Anschlussstifte ausgehend von der Unterseite des Trägerkörpers 11, die dazu bestimmt sind, in Bohrungen einer Leiterplatte einzugreifen. Diese relative Abmessung der Anschlussstifte und der Abstandhalterstifte geht beispielsweise aus Fig. 6 hervor.

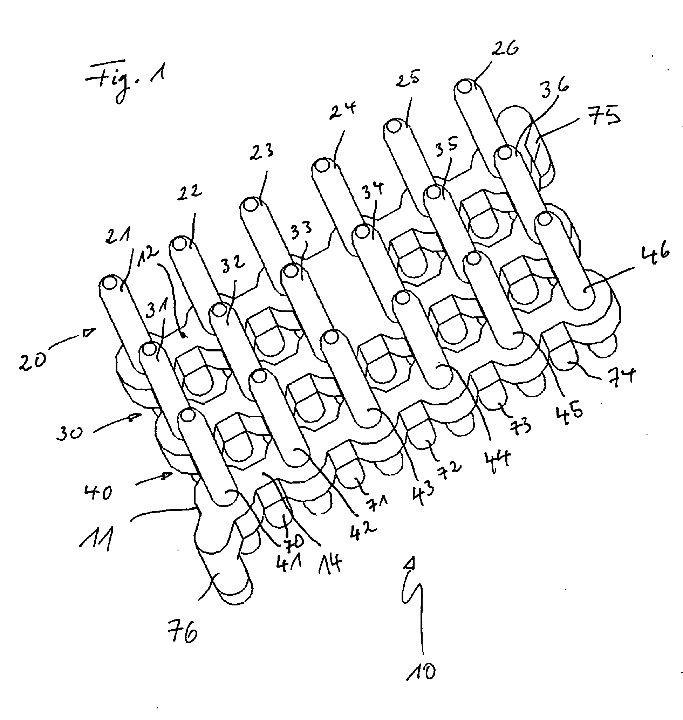

Um die gewünschte Positionierung des Anschlussstift-Array 10 auf einer Leiterplatte zu erleichtern bzw. zu gewährleisten, sind an der Unterseite des Trägerkörpers 11 Positionierungsmittel vorgesehen. Diese Positionierungsmittel sind in Form von Positionierungsstiften 75 und 76 an der Unterseite des Trägerkörpers 11 gebildet bzw. einstückig mit diesem gebildet, und zwar an zwei diametral gegenüberliegenden Ecken des Trägerkörpers 11, wie beispielsweise aus Fig. 1 und Fig. 4 hervorgeht. Die Erstreckungslänge der Positionierungsstifte 75 und 76 ausgehend von der Unterseite des Trägerkörpers 11 entspricht im Wesentlichen derjenigen der Anschlussstifte, da die Positionierungsstifte 75, 76 ebenso wie die Anschlussstifte bestimmt sind, in Durchbrüche bzw. Bohrungen einer Leiterplatte einzugreifen.

### Bezugszeichenliste

- 10: Anschlussstift-Array
- 11: Trägerkörper
- 12-14: Längssteg
- 15-19, 19a: Quersteg
- 20: erste Anschlussstift-Längsreihe
- 21-26: Anschlussstifte
- 21a-26a: Stiftaufnahme-Durchbruch
- 30: zweite Anschlussstiftlängsreihe
- 31-36: Anschlussstifte
- 31a-36a: Stiftaufnahme-Durchbruch
- 40: dritte Anschlussstiftlängsreihe
- 41-46: Anschlussstifte
- 41a-46a: Stiftaufnahme-Durchbruch
- 50-53: Stiftaufnahmebuchse
- 54-63: Durchbrüche
- 64: geschlossener Flächenbereich
- 65-69: Abstandhalterstifte
- 70-74: Abstandhalterstifte
- 75,76: Positionierungsstifte

## Patentansprüche

1. Anschlussstift-Array zur Montage auf und Reflow-Verlötung mit einer Leiterplatte, umfassend einen Trägerkörper (11) für Anschlussstifte (21-26, 31-36, 41-46), welcher eine durchbrochene Struktur und Abstandhalter 65-69; 70-74) auf der zur Leiterplatte weisenden Unterseite derart aufweist, dass bei der Reflow-Verlötung des Anschlussstiftarrays (10) auf der Leiterplatte im Bereich der Anschlussstifte (21-26, 31-36, 41-46) ein Luftaustausch zwischen Ober- und Unterseite des Trägerkörpers sowie zwischen den Anschlussstiften (21-26, 31-36, 41-46) gewährleistet ist, **dadurch gekennzeichnet, dass** der Trägerkörper (11) eine gitterartige Struktur mit sich kreuzenden, seitlich auf Abstand gesetzten Stegen (12-19, 19a) aufweist, wobei die Anschlussstifte (21-26, 31-36, 41-46) in den Kreuzungsstellen der Stege (12-19, 19a) vorgesehen sind.

2. Anschlussstiftarray nach Anspruch 1, **dadurch gekennzeichnet, dass** die Kreuzungsstellen der Stege (12- 19, 19a) quer zur Erstreckung der Anschlussstifte (21-26; 31-36, 41-46) verstärkt ausgebildet sind.

3. Anschlussstiftarray nach Anspruch 2, **dadurch gekennzeichnet, dass** die verstärkten Kreuzungsstellen als die Anschlussstifte umschließende, buchsenartige Bereiche (50-53) des gitterartigen Trägerkörpers (11) gebildet sind.

4. Anschlussstiftarray nach Anspruch 2 oder 3, **dadurch gekennzeichnet, dass** die Stege (12-19, 19a) in Draufsicht schmaler und in Seitenansicht stärker ausgebildet sind.

5. Anschlussstiftarray nach einem der Ansprüche 1 bis 4, **dadurch gekennzeichnet, dass** die Abstandhalter von der Unterseite des Trägerkörpers vorstehende Stifte (65-69, 70-74) sind.

6. Anschlussstiftarray nach einem der Ansprüche 1 bis 5, **dadurch gekennzeichnet, dass** von der Unterseite des Trägerkörpers (11) zum Eingriff in Ausnehmungen der Leiterplatte bestimmte Positionierungsvorsprünge (76, 76) vorstehen.

7. Anschlussstiftarray nach Anspruch 6, **dadurch gekennzeichnet, dass** die Positionierungsvorsprünge Stifte (75, 76) sind.

8. Anschlussstiftarray nach einem der Ansprüche 1 bis 7, **dadurch gekennzeichnet, dass** der Träger (11) auf seiner Oberseite einen geschlossenen Flächenbereich(64) zum Angriff eines Saugorgans einer Bestückungseinrichtung aufweist.

9. Anschlussstiftbereich nach Anspruch 8, **dadurch gekennzeichnet, dass** der geschlossene Flächenbereich (64) anstelle eines Durchbruchs zwischen Anschlussstiften vorgesehen ist.

10. Anschlussstiftarray nach einem der Ansprüche 1 bis 9, **dadurch gekennzeichnet, dass** der Trägerkörper (11) aus Kunststoff besteht.

11. Anschlussstiftarray nach Anspruch 12, **dadurch gekennzeichnet, dass** die Anschlussstifte (21-26, 31-36, 41-46) in den Trägerkörper eingeformt bzw. eingespritzt sind.

12. Anschlussstiftarray nach einem der Ansprüche 1 bis 11, **dadurch gekennzeichnet, dass** der Trägerkörper(11) flach und allgemein quaderförmig ist.

13. Leiterplatte, die mit zumindest einem Anschlussstiftarray (10) nach einem der Ansprüche 1 bis 12 bestückt ist.

## Claims

1. Terminal pin array for mounting on and reflow soldering to a circuit board, comprising a supporting body (11) for terminal pins (21-26, 31-36, 41-46), which has a pierced structure and spacers (65-69, 70-74) on the underside pointing towards the circuit board in such a way that, during the reflow soldering of the terminal pin array (10) on the circuit board, in the region of the terminal pins (21-26, 31-36, 41-46), an exchange of air between the upper side and underside of the supporting body and also between the terminal pins (21-26, 31-36, 41-46) is ensured, **characterized in that** the supporting body (11) is a grid-like structure having webs (12-19, 19a) crossing one another and placed laterally at intervals, the terminal pins (21-26, 31-36, 41-46) being provided at the crossing points of the webs (12-19, 19a).

2. Terminal pin array according to Claim 1, **characterized in that** the crossing points of the webs (12-19, 19a) are formed more densely transversely with respect to the extent of the terminal pins (21-26, 31-36,41-46).

3. Terminal pin array according to Claim 2, **characterized in that** the denser crossing points are formed as bush-like regions (50-53) of the grid-like supporting body (11) which enclose the terminal pins.

4. Terminal pin array according to Claim 2 or 3, **characterized in that** the webs (12-19, 19a) are formed so as to be narrower in plan view and thicker in side view.

5. Terminal pin array according to one of Claims 1 to 4, **characterized in that** the spacers are pins (65-69, 70-74) protruding from the underside of the supporting body.

6. Terminal pin array according to one of Claims 1 to 5, **characterized in that** positioning projections (76, 76) to engage in recesses in the circuit board protrude from the underside of the supporting body (11).

7. Terminal pin array according to Claim 6, **characterized in that** the positioning projections are pins (75, 76).

8. Terminal pin array according to one of Claims 1 to 7, **characterized in that**, on its upper side, the support (11) has a closed surface area (64) for the application of a suction element of a pick and place device.

9. Terminal pin array according to Claim 8, **characterized in that** the closed surface area (64) is provided instead of an aperture between terminal pins.

10. Terminal pin array according to one of Claims 1 to 9, **characterized in that** the supporting body (11) consists of plastic.

11. Terminal pin array according to Claim 12, **characterized in that** the terminal pins (21-26, 31-36, 41-46) are formed in or injection moulded into the supporting body.

12. Terminal pin array according to one of Claims 1 to 11, **characterized in that** the supporting body (11) is flat and generally parallelepipedal.

13. Circuit board which is fitted with at least one terminal pin array (10) according to one of Claims 1 to 12.

## Revendications

1. Réseau de broches de connexion destiné à être monté sur une plaquette de circuits imprimés et à être brasé par refusion sur celle-ci, comportant un corps de support (11) pour des broches de connexion (21-26, 31-36, 41-46), lequel possède une structure perforée et des écarteurs (65-69, 70-74) sur la face inférieure, orientée vers la plaquette de circuits imprimés, de telle sorte que, lors du brasage par refusion du réseau de broches de connexion (10) sur la plaquette de circuits imprimés dans la zone des broches de connexion (21-26, 31-36, 41-46), il est garanti un échange d'air entre la face supérieure et la face inférieure du corps de support et entre les broches de connexion (21-26, 31-30, 41-46), **caractérisé en ce que** le corps de support (11) comporte une structure en forme de grille avec des barrettes (12-19, 19a) se croisant et situées latéralement à distance, les broches de connexion (21-26, 31-36, 41-46) étant prévues dans les points d'intersection des barrettes (12-19, 19a).

2. Réseau de broches de connexion selon la revendication 1, **caractérisé en ce que** les points d'intersection des barrettes (12-19, 19a) sont renforcés transversalement à la projection des broches de connexion (21-26, 31-36, 41-46).

3. Réseau de broches de connexion selon la revendication 2, **caractérisé en ce que** les points d'intersection renforcés sont conçus sous forme de zones (50-53) en forme de douille du corps de support (11) en forme de grille, lesquelles entourent les broches de connexion.

4. Réseau de broches de connexion selon la revendication 2 ou 3, **caractérisé en ce que** les barrettes (12-19, 19a) sont plus étroites vues de dessus et sont plus épaisses vues de côté.

5. Réseau de broches de connexion selon l'une quelconque des revendications 1 à 4, **caractérisé en ce que** les écarteurs sont des tétons (65-69, 70-74) en saillie sur la face inférieure du corps de support.

6. Réseau de broches de connexion selon l'une quelconque des revendications 1 à 5, **caractérisé en ce que** des saillies de positionnement (75, 76) déterminées, destinées à s'engager dans des évidements de la plaquette de circuits imprimés, sont en saillie sur la face inférieure du corps de support (11).

7. Réseau de broches de connexion selon la revendication 6, **caractérisé en ce que** les saillies de positionnement sont des tétons (75, 76).

8. Réseau de broches de connexion selon l'une quelconque des revendications 1 à 7, **caractérisé en ce que** le corps de support (11) comporte sur sa face supérieure une zone plane (64) fermée pour la mise en contact d'un organe d'aspiration d'un dispositif destiné à la mise en place des composants.

9. Réseau de broches de connexion selon la revendication 8, **caractérisé en ce que** la zone plane (64) fermée est prévue à la place d'un trou débouchant entre les broches de connexion.

10. Réseau de broches de connexion selon l'une quelconque des revendications 1 à 9, **caractérisé en ce que** le corps de support (11) est réalisé en matière plastique.

11. Réseau de broches de connexion selon la revendication 12, **caractérisé en ce que** les broches de connexion (21-26, 31-36, 41-46) sont formées ou sont moulées par injection dans le corps de support.

12. Réseau de broches de connexion selon l'une quelconque des revendications 1 à 11, **caractérisé en ce que** le corps de support (11) est plan et parallélépipédique dans l'ensemble.

13. Plaquette de circuits imprimés qui est équipée d'au moins un réseau de broches de connexion (10) selon l'une quelconque des revendications 1 à 12.
